# EUROPEAN PATENT APPLICATION

(11) **EP 2 354 629 A1**
(43) Date of publication of application: **10.08.2011**
(21) Application number: 10152199.5
(22) Date of filing: 29.01.2010
(51) Int. Cl.: F21K 99/00, H01L 25/075, H05K 1/18, H05K 3/36

(54) **LED lamp for wide area lighting**

(71) Applicant: Lin, Chiu-Min, Taoyuan County (TW)
(72) Inventor: Lin, Chiu-Min, Taoyuan County (TW)
(74) Representative: Lang, Christian

(57) **Abstract**

An LED lamp with improved lighting area has a lamp base, a substrate assembly (20) mounted on the lamp base and a cap (30) engaged with the lamp base to enclose the substrate assembly (20) therein. The substrate assembly (20) has multiple substrates (21a-21d) intersecting each other. Multiple LEDs (22) are mounted on the substrates (21a-21d) to form a spherical distribution that allows the LED lamp to provide wide-angled lighting.

## Description

### 1. Field of the Invention

The present invention relates to a Light-emitting diode (LED) lamp, especially to an LED lamp having multiple LEDs arranged in a spherical configuration to provide wide-angled lighting.

### 2. Description of the Related Art

Although LED-based light bulbs consume lower power than fluorescent lamps, the applications of the LED bulbs are limited due to thermal dissipation problems. As temperature rises, efficiency and life time of the LEDs will reduce. Furthermore, the LEDs of the conventional LED bulb emit light toward a direction and only illuminate a small area. For some applications requiring wide area lighting, the conventional LED bulbs cannot provide the needed lighting effect.

To overcome the shortcomings, the present invention provides an LED lamp for wide area lighting to mitigate or obviate the aforementioned problems.

The main objective of the invention is to provide an LED lamp for wide area lighting, wherein multiple LEDs of the LED lamp are distributed in a spherical configuration to increase illuminating area and the heat generated by the LEDs can be dissipated to ensure lighting efficiency.

To achieve the objective, an LED lamp of the present invention has a lamp base, a substrate assembly mounted on the lamp base and a cap engaged with the lamp base to enclose the substrate assembly therein. The substrate assembly has multiple substrates intersecting each other. Multiple LEDs are mounted on the substrates to form a spherical distribution that allows the LED lamp to provide a substantial directionless and wide-angled lighting.

Other objectives, advantages and novel features of the invention will become more apparent from the following detailed description when taken in conjunction with the accompanying drawings.

In the drawings:
Fig. 1 is an exploded perspective view of an LED lamp in accordance with the present invention; and
Fig. 2 is another exploded perspective view of the LED lamp in accordance with the present invention;
Figs. 3A to 3D are plan views of different substrates mounted in the LED lamp in accordance with the present invention; and
Fig. 4 is a cross sectional view of a part of the LED lamp in accordance with the present invention.

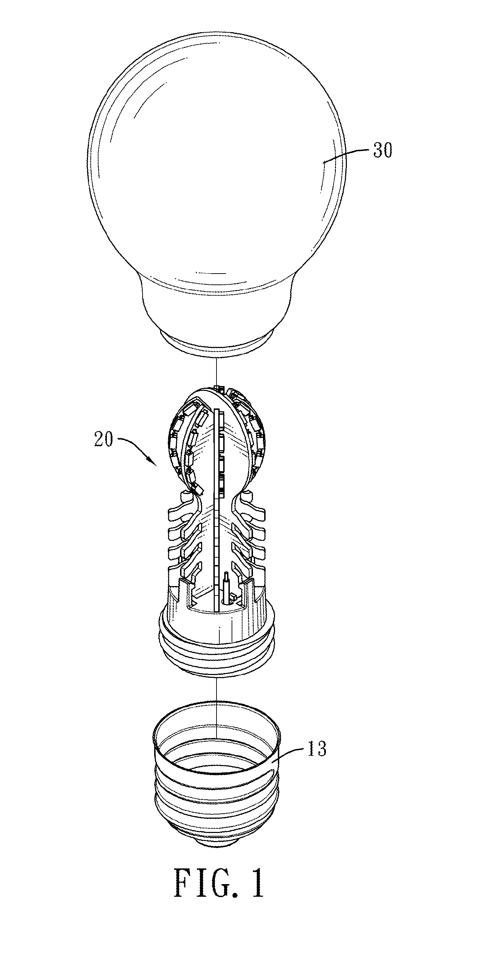

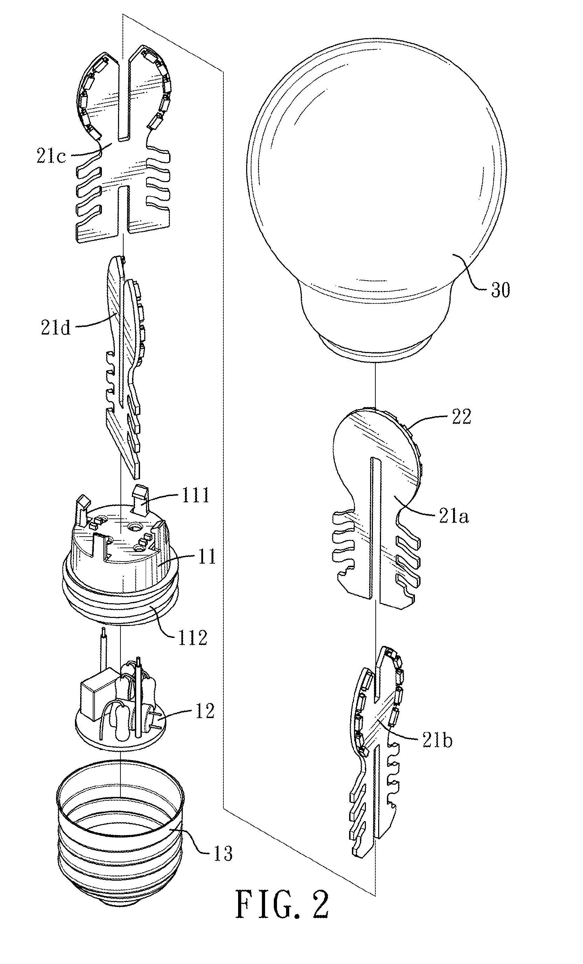

With reference to Figs. 1 and 2, an LED lamp in accordance with the present invention comprises a lamp base, a substrate assembly 20 and a cap 30.

The lamp base comprises a mounting base 11, a circuit module 12 and an outer contact 13. The mounting base 11 includes a top surface, a bottom surface, multiple hooks 111 and a hollow threaded plug 112. The hooks 111 protrude upwardly from the top surface of the mounting base 11. The threaded plug 112 is formed on and protrudes downwardly from the bottom surface of the mounting base 11. The circuit module 12 is held in the hollow threaded plug 112. The outer contact 13 is correspondingly screwed to the threaded plug 112.

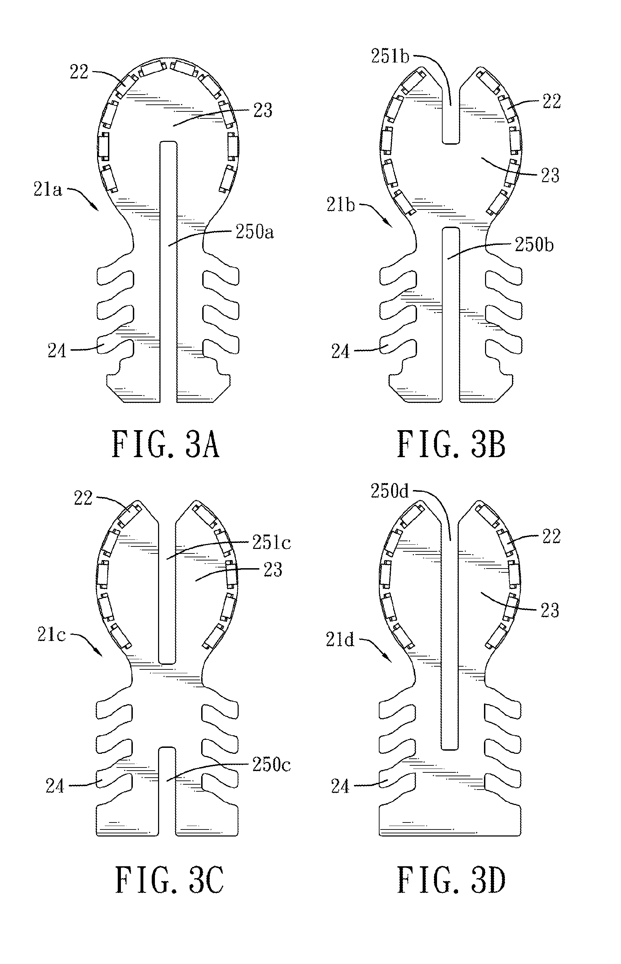

With further reference to Figs 3A to 3D, the substrate assembly 20 comprises multiple substrates 21a-21d and multiple light emitting diodes (LEDs) 22 mounted on the substrates 21a-21d. Each of the substrates 21a-21d is a racket-shaped substrate and has a high thermal conductivity in the embodiment. Each substrate 21a-21d has a substantial elliptical upper portion as an LED mounting area 23 and a substantial elongated lower portion integrally extending from the elliptical upper portion. The LEDs 22 are preferably arranged on the same surface of the substrate 21a-21d around a periphery of the LED mounting area 23. Each substrate 21a-21d further has multiple fins 24 protruding symmetrically from opposite edges of the elongated lower portion.

The first substrate 21a has one slot 250a that extends lengthwise from a bottom edge of the elongated lower portion to the LED mounting area 23.

The second substrate 21b further has a lower slot 250b and an upper slot 251b that extend from the bottom edge of the elongated lower portion and from a top edge of the LED mounting area 23 respectively, wherein the lower slot 250b is longer than the upper slot 251b in length.

The third substrate 21c also has a lower slot 250c and an upper slot 251c that extend from the bottom edge of the elongated lower portion and from the top edge of the LED mounting area 23 respectively and toward each other, wherein the lower slot 250c is shorter than the upper slot 251c in length.

The fourth substrate 21d has one slot 250d extending from the top edge of the LED mounting area 23.

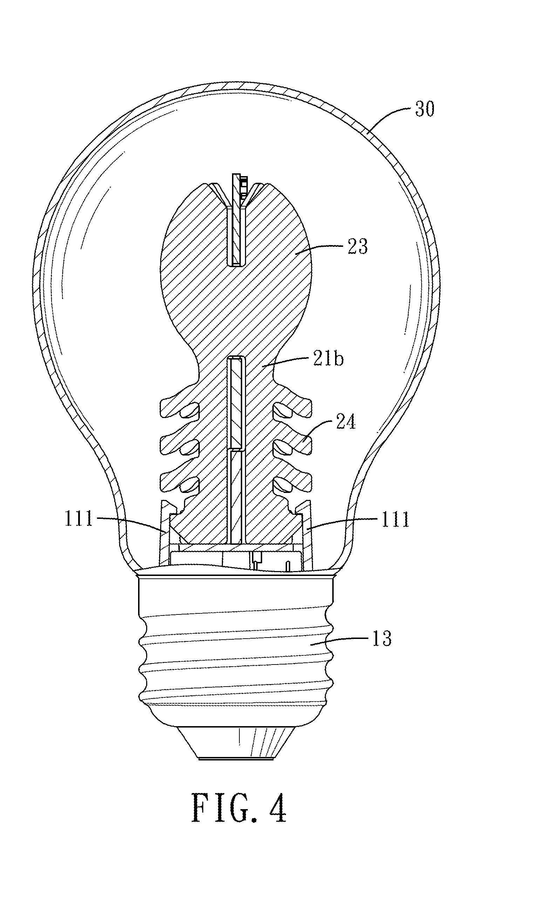

With further reference to Fig. 4, the four substrates 21a-21d are intersected and engaged together with the slots 25a-25d to form a substantially cylindrical assembly. The LEDs 22 are controlled by the circuit module 12 and mounted on the LED mounting areas 23 of the assembled substrates 21a-21d to form a substantial spherical distribution, thereby accomplishing directionless lighting. In this embodiment, the bottom edges of the first and second substrates 21a, 21b are engaged with the hooks 111 to securely attach the assembled substrates 21a-21d to the mounting base 11.

The cap 30 is substantially bulb-shaped and mounted on the lamp base to enclose the substrate assembly 20 therein. Preferably, the cap 30 is transparent to allow the LEDs 22 to emit light outward.

In short, the heat generated by the LEDs can be conducted to the substrates and dissipated quickly. Since each substrate has a relative large area and multiple fins, the thermal dissipation efficiency can be improved. Furthermore, the spherical distribution of the LEDs allows the LED lamp to provide a substantial directionless lighting, thereby illuminating a relative larger area.

## Claims

1. An LED lamp for wide area lighting, **characterized in that** the LED lamp comprises:
a lamp base;
a substrate assembly (20) mounted on the lamp base and comprising multiple substrates (21a-21d), each of the substrates (21a-21d) having multiple light emitting diodes (LEDs) (22) mounted on the same surface of the substrate (21a-21d), the LEDs (22) on the multiple substrates (21a-21d) forming a substantial spherical distribution;
a cap (30) engaged with the lamp base to enclose the substrate assembly (20).

2. The LED lamp as claimed in claim 1, wherein each of the substrates (21a-21d) has an upper portion as an LED mounting area (23) and a lower portion integrally extending from the LED mounting area (23), and the LEDs (22) are mounted around a periphery of the LED mounting area (23).

3. The LED lamp as claimed in claim 2, wherein each of the substrates (21a-21d) further comprises multiple fins (24) extending from opposite edges of the elongated lower portion.

4. The LED lamp as claimed in claim 2, wherein the upper portion of each substrate (21a-21d) is substantially elliptical, and the lower portion of each substrate (21a-21d) is substantially elongated.

5. The LED lamp as claimed in claim 3, wherein the upper portion of each substrate (21a-21d) is substantially elliptical, and the lower portion of each substrate is substantially elongated.

6. The LED lamp as claimed in claim 1, wherein each of the substrates (21a-21d) has at least one slot, and the substrates (21a-21d) are intersected via the slots.

7. The LED lamp as claimed in claim 2, wherein the substrate assembly (20) comprises a first substrate (21a), a second substrate (21b), a third substrate (21c) and a fourth substrate (21d), wherein
the first substrate (21a) has a slot (250a) extending from a bottom edge of the lower portion to the LED mounting area (23) of the first substrate (21a);
the second substrate (21b) has a lower slot (250b) and an upper slot (251b) that extend toward each other, the lower slot (250b) extends from a bottom edge of the lower portion of the second substrate (21b), and the upper slot (251b) is shorter than the upper slot (250b) and extends from a top edge of the LED mounting area (23) of the second substrate (251b);
the third substrate (21c) has a lower slot (250c) and an upper slot (251c) that extend toward each other, the lower slot (250c) extends from a bottom edge of the lower portion of the third substrate (21c), and the upper slot (251c) is longer than the lower slot (250c) and extends from a top edge of the LED mounting area (23) of the third substrate (21c); and
the fourth substrate (21d) has a slot (250d) extending from a top edge of the LED mounting area (230) to the lower portion of the fourth substrate (21d).

8. The LED lamp as claimed in any claim of claim 1 to 7, wherein the lamp base comprises:
a mounting base (11) having a top surface, a bottom surface, multiple hooks (111) protruding upwardly from the top surface and a hollow threaded plug (112) formed on and protruding downwardly from the bottom surface;
a circuit module (12) mounted in the threaded plug (112) of the mounting base (11); and
an outer contact (13) screwed to the threaded plug (112) of the mounting base (11).
